# EUROPEAN PATENT APPLICATION

(11) **EP 4 739 040 A1**
(43) Date of publication of application: **06.05.2026**
(21) Application number: 23943586.0
(22) Date of filing: 27.06.2023
(51) Int. Cl.: H10F 55/00, H10F 77/00

(54) **REFLECTIVE OPTICAL SEMICONDUCTOR DEVICE AND METHOD FOR MANUFACTURING SAME**

(71) Applicant: Nisshinbo Micro Devices Inc., Tokyo 103-8456 (JP)
(72) Inventor: OHNO, Fumiaki, Fujimino-shi, Saitama 356-8510 (JP); FUJII, Yoshio, Tokyo 103-8456 (JP); KATO, Masayuki, Fujimino-shi, Saitama 356-8510 (JP); TANAKA, Ryosuke, Tokyo 103-8456 (JP)
(74) Representative: M. Zardi & Co S.A.
(86) International application number: PCT/JP2023/023823
(87) International publication number: WO 2025/004187

(57) **Abstract**

A reflection type optical semiconductor device includes a light-emitting element chip (2), a light-receiving element chip (1), and a mounting part (3), in which the light-receiving element chip (1) is mounted to the mounting part (3) by means of an insulating member (12), the light-emitting element chip (2) is mounted to a mounting part electrode (13C) disposed inside a through hole (14) of the light-receiving element chip (1) by means of a conductive member (11), and the conductive member (11) is covered by the insulating member (12); and a method of manufacturing a reflection type optical semiconductor device includes applying an insulating member (12) to a mounting part (3) to which a light-emitting element chip (2) is connected and mounted by means of a conductive member (11), placing a light-receiving element chip (1) onto the insulating member (12), pressing the light-receiving element chip (1), and covering the conductive member (11) by means of the pushed-out insulating member (12).

## Description

### TECHNICAL FIELD

The present invention relates to a reflection type optical semiconductor device composed of a light-emitting element chip comprising a light-emitting element and a light-receiving element chip comprising a light-receiving element, and a manufacturing method thereof.

### BACKGROUND ART

A reflection type optical sensor used in a reflection type encoder is made to have a configuration in which a light emitted from a light-emitting element provided to a reflection type optical semiconductor device is reflected by a reflector disposed so as to face the reflection type optical semiconductor device, and the light incidents to a light-receiving element, so that a detection signal can be obtained.

Generally, in the case where a reflection type optical semiconductor device is mounted on a mounting part, a configuration is made in a manner that a light-emitting element chip is stacked on a light-receiving element chip and the light-receiving element chip is mounted to the mounting part (Patent Document 1, for example), or alternatively, a configuration is made in a manner that a light-receiving element chip comprising a through hole and a light-emitting element chip disposed inside the through hole are mounted to the mounting part (Patent Document 2, for example).

### PRIOR ART DOCUMENT

### Patent Document

Patent Document 1: JP 2009-182028 A
Patent Document 2: JP 2005-121593 A

### SUMMARY OF THE INVENTION

### PROBLEM TO BE SOLVED BY THE INVENTION

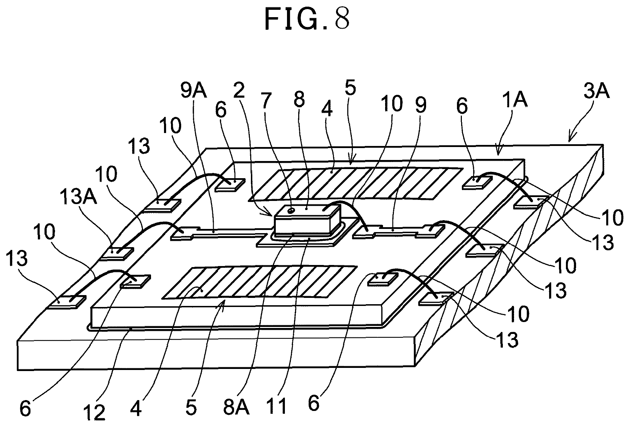

FIG. 8 is an explanation view showing an example of a reflection type optical semiconductor device having a configuration in which a light-emitting element chip 2 is stacked on a light-receiving element chip 1A and the light-receiving element chip 1A is mounted to a mounting part 3A. On the light-receiving element chip 1A, a light-receiving element array 5 composed of a plurality of light-receiving elements 4 is disposed. The light-receiving element 4 can be composed of a photodiode, for example. A cathode or an anode of a photodiode is connected to a light-receiving element electrode 6 disposed on an upper surface (light-receiving surface) of a light-receiving element chip 1A by means of a wiring or the like (not shown), respectively.

A light-emitting element is disposed on the light-emitting element chip 2. The light-emitting element can be composed of a light-emitting diode, for example. On an upper surface (light-emitting surface) of the light-emitting element chip 2, a light-emitting portion 7 from which a light is emitted and a light-emitting element electrode 8 connected to a cathode of the light-emitting diode are disposed, and on the lower surface (mounting surface) of the light-emitting element chip 2, a light-emitting element electrode 8A connected to an anode of the light-emitting diode is disposed. The light-emitting element electrode 8 is connected to a light-emitting element wiring 9 disposed on the light-receiving surface of the light-receiving element chip 1A by means of a metal wire 10, the light-emitting element electrode 8A is connected to a light-emitting element wiring 9A disposed on the light-receiving surface of the light-receiving element chip 1A by means of a conductive member 11 composed of a silver paste or the like, for example, and the light-emitting element chip 2 is stacked on the light-receiving element chip 1A.

The light-receiving element chip 1A on which the light-emitting element chip 2 is stacked is glued and mounted to a mounting part 3A composed of an organic substrate or the like, for example, by means of an insulating member 12 that becomes an adhesive. On the mounting part 3A, mounting part electrodes 13, 13A are disposed, in which each mounting part electrode 13 is connected to any of the light-receiving element electrode 6 and the light-emitting element wiring 9 disposed on the light-receiving surface of the light-receiving element chip 1A, and the mounting part electrode 13A is connected to the light-emitting element wiring 9A, by means of the metal wire 10.

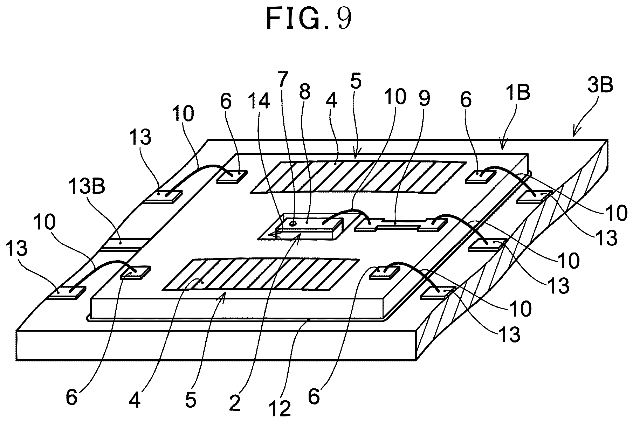

FIG. 9 is an explanation view showing another example of the reflection type optical semiconductor device having a configuration in which a light-receiving element chip 1B comprising a through hole 14 and a light-emitting element chip 2 disposed inside the through hole 14 are mounted to a mounting part 3B. On the light-receiving element chip 1B, as similar to the light-receiving element chip 1A shown in FIG. 8, a light-receiving element array 5 composed of a plurality of light-receiving elements 4, a light-receiving element electrode 6, and a light-emitting element wiring 9 are disposed. Further, unlike the light-receiving element chip 1A, the light-receiving element chip 1B is made to have a configuration in which a light-emitting element wiring 9A is not disposed and the through hole 14 is disposed at the center thereof.

The light-emitting element chip 2 is made to have a similar configuration to the light-emitting element chip 2 shown in FIG. 8. As shown in FIG. 9, the light-emitting element chip 2 is disposed inside the through hole 14 of the light-receiving element chip 1B, the light-emitting element electrode on the mounting surface of the light-emitting element chip 2 is connected to the mounting part electrode 13B disposed inside the through hole 14 by means of a conductive member, and the light-emitting element chip 2 is mounted to the mounting part 3B. The light-emitting element electrode 8 disposed on the light-emitting surface on the light-emitting element chip 2 is connected, by means of the metal wire 10, to the light-emitting element wiring 9 disposed on the upper surface (light-receiving surface) of the light-receiving element chip 1B.

The light-receiving element chip 1B is glued and mounted to the mounting part 3B composed of an organic substrate or the like, for example, by means of the insulating member 12 that becomes an adhesive. The mounting part electrode 13 is disposed on the mounting part 3B as similar to the mounting part 3A, and each mounting part electrode 13 is connected to any of the light-receiving element electrode 6 and the light-emitting element wiring 9 by means of the metal wire 10.

The mounting part electrode 13B is made to have a configuration which is continuous to the inside of the through hole 14 and in which an end that is larger than the bottom face of the light-emitting element chip 2 is disposed inside the through hole 14. The mounting part electrode 13B configured in this way is connected to the light-emitting element electrode on the mounting surface of the light-emitting element chip 2 by means of a conductive member, in a similar way to the connection between the light-emitting element electrode 8A and the light-emitting element wiring 9A shown in FIG. 8. Since the mounting part electrode 13B is disposed under the light-receiving element chip 1B in this way, the light-receiving element chip 1B is glued onto a part of the mounting part electrode 13B and the mounting part 3B by means of the insulating member 12 that becomes an adhesive, and mounted to the mounting part 3B.

In the reflection type optical semiconductor device shown in FIG. 8 and FIG. 9, if the light-emitting surface of the light-emitting element chip 2 is covered by a coating resin or the like, a light emitted from the light-emitting portion 7 is diffused due to a lens effect of the coating resin, or a variation in directivity occurs due to a variation in thickness of the coating resin. Therefore, the light-emitting surface of the light-emitting element chip 2 is not covered by a coating resin and mounted in a state where it is exposed to the outside air. Meanwhile, the conductive member 11 connecting the light-emitting element electrode 8A on the mounting surface of the light-emitting element chip 2 with the light-emitting element wiring 9A or the mounting part electrode 13B is covered by a coating material for ensuring reliability of the reflection type optical semiconductor device. Particularly in the case where a material containing silver is used as the conductive member 11, sulfurization or migration of silver occurs, and reliability of the reflection type optical semiconductor device is degraded, and thus, the surface of the conductive member 11 is covered by a coating resin.

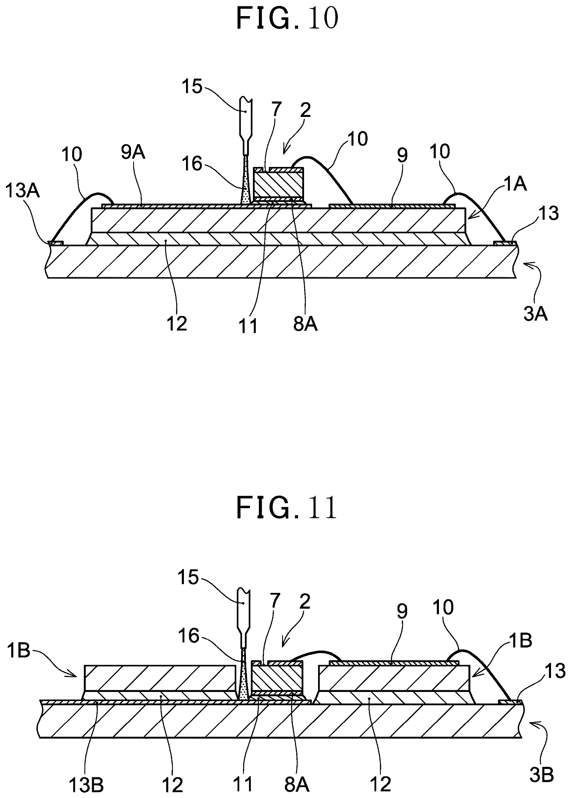

FIG. 10 is a schematic cross-sectional view explaining an application method of a coating resin in the reflection type optical semiconductor device shown in FIG. 8, and is equivalent to a cross-sectional view in the left and right direction of the figure passing through the center of the light-emitting element chip 2 and the light-emitting element wirings 9, 9A in the reflection type optical semiconductor device shown in FIG. 8. As shown in FIG. 10, in the case where the conductive member 11 is covered by a coating resin 16 discharged from a dispenser 15, a large space exists around the light-emitting element chip 2, and thus the coating resin 16 can be applied on the conductive member 11 while avoiding the light-emitting surface of the light-emitting element chip 2, without a precise positioning of the dispenser 15, a discharge amount control, or the like.

Meanwhile, FIG. 11 is a schematic cross-sectional view explaining an application method of a coating resin in the reflection type optical semiconductor device shown in FIG. 9, and is equivalent to a cross-sectional view in the left and right direction of the figure passing through the center of the light-emitting element chip 2, the light-emitting element wiring 9, and the mounting part electrode 13B in the reflection type optical semiconductor device shown in FIG. 9. As shown in FIG. 11, in order to cover the conductive member 11 by the coating resin 16, it is necessary to discharge the coating resin 16 from the dispenser 15 into the through hole 14.

In order to perform a highly accurate sensing in a general reflection type optical semiconductor device, it is necessary to reduce a variation in positioning of the light-receiving element chip 1B and the light-emitting element chip 2. Therefore, it is preferable that an interval between the through hole 14 and the light-emitting element chip 2 is set to be narrow. In order to discharge the coating resin 16 into this small interval, a precise positioning of the dispenser 15 and a discharge amount control of the coating resin 16 are required, and the time period required for the application step of the coating resin 16 becomes longer. Further, if the positioning or the discharge amount control is performed at a low precision for the purpose of completing the application step in a short period of time, there arises a problem that a location of the dispenser 15 is displaced, and thus, the light-emitting surface of the light-emitting element chip 2 is covered by the coating resin 16, and a part of the conductive member 11 is exposed without being covered.

Therefore, it is an object of the present invention to provide a reflection type optical semiconductor device in which the conductive member is surely and simply covered, and a manufacturing method thereof.

### MEANS TO SOLVE THE PROBLEM

A reflection type optical semiconductor device in an aspect of the present invention comprises: a light-emitting element chip comprising a light-emitting element and a light-emitting element electrode; a light-receiving element chip comprising a light-receiving element, a light-receiving element electrode, a light-emitting element wiring connected to the light-emitting element electrode, and a through hole in which the light-emitting element chip is disposed; and a mounting part in which a mounting part electrode to be connected to any of the light-emitting element electrode, the light-receiving element electrode, and the light-emitting element wiring is disposed, wherein the light-receiving element chip, in which the light-receiving element electrode and the light-emitting element wiring are disposed on a light-receiving surface, is mounted on the mounting part by means of an insulating member; wherein the light-emitting element chip, in which the light-emitting element electrode is disposed on each of a light-emitting surface and a mounting surface, is mounted on the mounting part by connecting the light-emitting element electrode on the mounting surface to the mounting part electrode disposed inside the through hole by means of a conductive member, wherein the conductive member is covered by the insulating member mounting the light-receiving element chip on the mounting part; wherein the light-emitting element electrode on the light-emitting surface in the light-emitting element chip is connected to the light-emitting element wiring by means of a metal wire; and wherein the light-receiving element electrode and the light-emitting element wiring are each connected to the mounting part electrode by means of a metal wire.

Further, a method of manufacturing a reflection type optical semiconductor device in another aspect of the present invention comprises: a first step of mounting a light-emitting element chip comprising a light-emitting element and, on a light-emitting surface and a mounting surface, a light-emitting element electrode to a mounting part by connecting the light-emitting element electrode disposed on the mounting surface to a mounting part electrode of the mounting part by means of a conductive member; a second step of applying an insulating member to an area in the mounting part where a light-receiving element chip is disposed; a third step of placing the light-receiving element chip comprising a light-receiving element, a light-receiving element electrode, a light-emitting element wiring to be connected to the light-emitting element electrode, and a through hole to the mounting part with the insulating member applied thereto, in a manner that the light-emitting element chip is disposed inside the through hole; a fourth step of pressing the insulating member by means of the light-receiving element chip, pushing out the insulating member from between the light-receiving element chip and the mounting part, and covering the conductive member exposed to the inside of the through hole by means of the pushed-out insulating member; a fifth step of curing the insulating member to mount the light-receiving element chip to the mounting part; and a sixth step of connecting, by means of a metal wire, the light-emitting element electrode disposed on the light-emitting surface of the light-emitting element chip and the light-emitting element wiring disposed on the light-receiving surface of the light-receiving element chip, as well as the light-receiving element electrode disposed on the light-receiving surface of the light-receiving element chip and the light-emitting element wiring to the mounting part electrode, respectively.

### EFFECTS OF THE INVENTION

According to the reflection type optical semiconductor device of the present invention, the conductive member is surely covered by the insulating member, and the light-emitting surface of the light-emitting element chip is not covered by the insulating member, so that it becomes possible to provide a reflection type optical semiconductor device having an excellent directivity property and a high reliability. Further, according to the method of manufacturing a reflection type optical semiconductor device in the present invention, the insulating member is pushed out by pressing the insulating member with the light-receiving element chip, and the conductive member can be covered by the pushed-out insulating member, so that it becomes possible to manufacture a reflection type optical semiconductor device having an excellent directivity property and a high reliability in a simple way.

### BRIEF DESCRIPTION OF THE DRAWINGS

FIG. 1 is an explanation view of an embodiment of a reflection type optical semiconductor device (Embodiment 1) in an aspect of the present invention.
FIG. 2 is a schematic cross-sectional view of the reflection type optical semiconductor device in FIG. 1.
FIG. 3 is an explanation view explaining a directivity property of a light-emitting element disposed on a light-emitting element chip in Embodiment 1.
FIG. 4 is an explanation view in an embodiment of a first step of a manufacturing method of a reflection type optical semiconductor device in another aspect of the present invention.
FIG. 5 is an explanation view in an embodiment of a second step of a manufacturing method of a reflection type optical semiconductor device in another aspect of the present invention.
FIG. 6 is an explanation view in an embodiment of a third step of a manufacturing method of a reflection type optical semiconductor device in another aspect of the present invention.
FIG. 7 is an explanation view in an embodiment of a fourth step of a manufacturing method of a reflection type optical semiconductor device in another aspect of the present invention.
FIG. 8 is an explanation view showing an example of a reflection type optical semiconductor device.
FIG. 9 is an explanation view showing another example of a reflection type optical semiconductor device.
FIG. 10 is a schematic cross-sectional view explaining an application method of a coating resin in the reflection type optical semiconductor device in FIG. 8.
FIG. 11 is a schematic cross-sectional view explaining an application method of a coating resin in the reflection type optical semiconductor device in FIG. 9.

### EMBODIMENT FOR CARRYING OUT THE INVENTION

Next, an embodiment of a reflection type optical semiconductor device and an embodiment of a manufacturing method thereof according to the present invention are explained with reference to the drawings, but the present invention is not limited to these embodiments, and members, materials, and the like described below can be variously modified within the scope of the spirit of the present invention. Further, the same reference sign in the drawings indicates an equivalent or the same component, and relationships in terms of size, position, and the like among respective components are merely for the purpose of convenience and may not strictly reflect their actual states.

### (Reflection type optical semiconductor device)

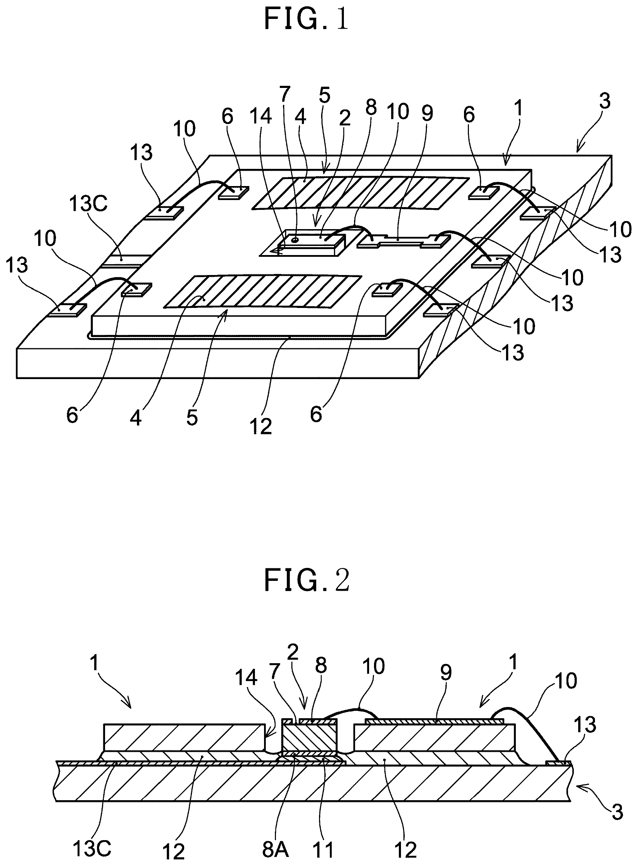

Firstly, an embodiment of a reflection type optical semiconductor device is explained as an aspect of the present invention. FIG. 1 is an explanation view of an embodiment (Embodiment 1) of the reflection type optical semiconductor device of the present invention, and FIG. 2 is a schematic cross-sectional view of the reflection type optical semiconductor device in Embodiment 1 shown in FIG. 1, and is equivalent to a cross-sectional view in the left and right direction of the figure passing through the center of the light-emitting element chip 2, the light-emitting element wiring 9, and the mounting part electrode 13C in FIG. 1. As shown in FIG. 1 and FIG. 2, the reflection type optical semiconductor device in the present embodiment has a configuration in which a light-receiving element chip 1 comprising a through hole 14 and a light-emitting element chip 2 disposed inside the through hole 14 are mounted to a mounting part 3. On the light-receiving element chip 1, a light-receiving element array 5 is disposed which is composed of a plurality of light-receiving elements 4. The light-receiving element 4 can be composed of a photodiode, for example. A cathode or an anode of the photodiode is connected to a light-receiving element electrode 6 disposed on the upper surface (light-receiving surface) of the light-receiving element chip 1 by means of a wiring (not shown), respectively.

A light-emitting element is disposed on the light-emitting element chip 2. The light-emitting element can be composed of a light-emitting diode, for example. On the upper surface (light-emitting surface) of the light-emitting element chip 2, a light-emitting portion 7 from which a light is emitted and a light-emitting element electrode 8 connected to a cathode of the light-emitting diode are disposed, and on the lower surface (mounting surface) of the light-emitting element chip 2, a light-emitting element electrode 8A connected to an anode of the light-emitting diode is disposed. The light-emitting element electrode 8 is connected to a light-emitting element wiring 9 disposed on the light-receiving surface of the light-receiving element chip 1 by means of a metal wire 10. The metal wire 10 is formed at a location, in a shape, and the like that do not block a light emitted from the light-emitting portion 7 of the light-emitting element chip 2. For example, the metal wire 10 is formed so as not to be disposed in an area within a light emission angle at ±60°, as an example. Further, the light-emitting element electrode 8A disposed on the mounting surface of the light-emitting element chip 2 is connected to a mounting part electrode 13C disposed inside the through hole 14 by means of a conductive member 11 such as a silver paste, and the light-emitting element chip 2 is mounted to the mounting part 3.

As shown in FIG. 1, the mounting part electrode 13C has a configuration in which a part thereof is exposed on the mounting part 3, the mounting part electrode 13C is continuous to the inside of the through hole 14, and an end, of the mounting part electrode 13C, larger than the mounting surface of the light-emitting element chip 2 is disposed inside the through hole 14. The mounting part electrode 13C configured in this way is connected to the light-emitting element electrode 8A on the mounting surface of the light-emitting element chip 2 by means of the conductive member 11. As shown in FIG. 1, the mounting part electrode 13C is disposed under the light-receiving element chip 1, and thus the light-receiving element chip 1 is glued onto a part of the mounting part electrode 13C and the mounting part 3 by means of an insulating member 12 that becomes an adhesive, and is mounted to the mounting part 3.

The conductive member 11 may be affected by the outside air to cause sulfurization or migration, and it is not preferable for the conductive member 11 to be exposed to the outside air. Accordingly, as shown in FIG. 2, the light-receiving element chip 1 is configured to be glued onto a part of the mounting part electrode 13C and the mounting part 3 composed of an organic substrate or the like, for example, by means of the insulating member 12, and to be mounted to the mounting part 3, and further, the insulating member 12 is configured to cover the conductive member 11.

When such a configuration is adopted, the insulating member 12 functions as an adhesive that glues the light-receiving element chip 1 to the mounting part 3, and is selected from materials that function as a coating material of the conductive member 11. For example, it can be selected from an epoxy resin, a phenolic resin, polyimide, and the like. Particularly in the case where the conductive member is a material containing silver such as a silver paste, it is preferable to select a material impermeable to a sulfurizing gas in order to prevent sulfurization of silver. Specifically, a fluorine resin is preferable which is impermeable to a sulfurizing gas and also has a viscosity that allows for changing its shape so as to cover the conductive member 11, and quick-drying and heat resistance properties required for a manufacturing step or as a reflection type optical semiconductor device, and the surface of which after curing is a non-adhesive which does not allow dirt, dust, and the like to adhere.

The insulating member 12 is applied in a state of paste, dried and cured, so that the light-receiving element chip 1 is glued and mounted to the mounting part 3. Typically, in a reflection type optical sensor, it is preferable to have a configuration in which a distance until a light emitted from the light-emitting element reaches a reflector and a distance until the light reflected by the reflector reaches the light-receiving element from the reflector are equal, which improves a sensing accuracy. Accordingly, it is preferable to make the height of the light-receiving surface of the light-receiving element chip 1 provided in the reflection type optical semiconductor device and the height of the light-emitting surface of the light-emitting element chip 2 to be the same (in other words, to make a position in the height direction of the upper surface of the light-receiving element chip 1 and a position in the height direction of the upper surface of the light-emitting element chip 2 to be the same) with each other, in the state where the light-receiving element chip is mounted to the mounting part 3. It is preferable for them to be mounted at least in a manner that a difference between the position in the height direction of the upper surface of the light-receiving element chip 1 and the position in the height direction of the upper surface of the light-emitting element chip 2 becomes 40µm or less.

On the mounting part 3, a mounting part electrode 13 is disposed, and each mounting part electrode 13 is connected to any of the light-receiving element electrode 6 and the light-emitting element wiring 9 by means of the metal wire 10. The metal wire 10 connecting any of the light-receiving element electrode 6 and the light-emitting element wiring 9 to the mounting part electrode 13 may be sealed by an epoxy resin or the like, for example.

As described above, the reflection type optical semiconductor device in the present embodiment has a configuration in which the conductive member 11 inside the through hole 14 is covered by the insulating member 12 mounting the light-receiving element chip 1 to the mounting part 3. Therefore, as described in FIG. 11, there is no need to cover the conductive member 11 by the coating resin 16 to be discharged from the dispenser 15 disposed on the side of the light-emitting surface of the light-emitting element chip 2 into the through hole 14, and there is no risk that the light-emitting surface of the light-emitting element chip 2 is covered by the coating resin 16. Thus, the reflection type optical semiconductor device in the present embodiment is a reflection type optical semiconductor device in which the light-emitting surface of the light-emitting element chip 2 is exposed without being covered by a coating resin or the like and thus the light emitted from the light-emitting element chip 2 is not diffused, and which has an excellent directivity property with a good symmetry of directivity and a narrow directivity angle.

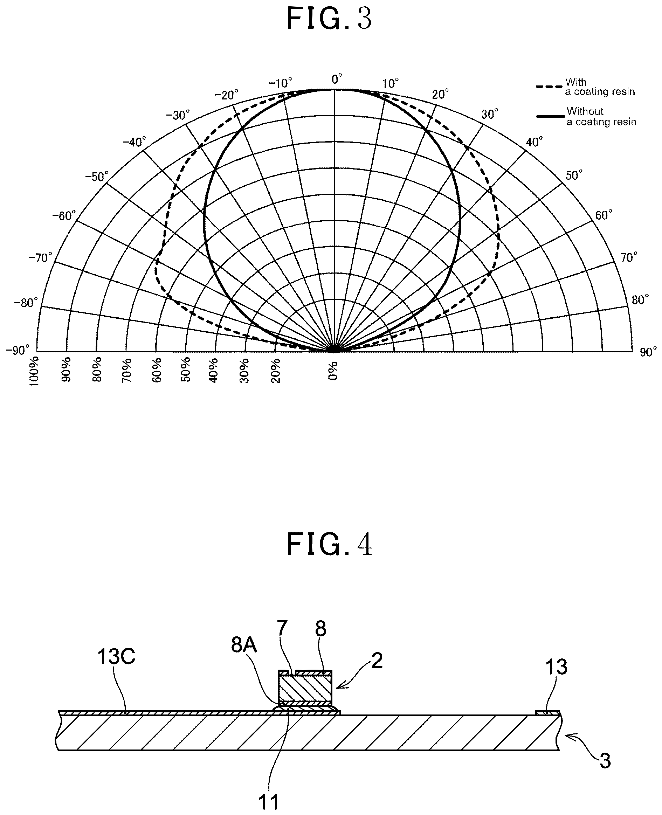

FIG. 3 is a directivity property view showing a directivity property of the light-emitting element disposed on the light-emitting element chip 2 in the reflection type optical semiconductor device in Embodiment 1 shown in FIG. 1. The directivity property view shown in FIG. 3 is a view representing a spread of a light emitted from the center of the light-emitting portion 7 with a relative brightness (relative luminosity) in each angle. The numerical values on the circumference of the semicircle represent emitted light angles, the linear portions indicating a radius of the semicircle show relative luminosities, and the brightness at the brightest portion is represented as 100% in the relative luminosity. In FIG. 3, a directivity property of the light-emitting element in the present embodiment without a coating resin on the light-emitting surface of the light-emitting element chip is shown by the solid line, and a directivity property of a light-emitting element in which the light-emitting surface of the light-emitting element chip is covered by a coating resin is shown by the dashed line, as the comparative example. As shown in FIG. 3, it can be seen that the light-emitting element in the present embodiment has an excellent directivity property with a better symmetry of directivity and a narrower directivity angle than those in the comparative example.

### (Manufacturing method of reflection type optical semiconductor device)

Next, as another aspect of the present invention, an embodiment of a manufacturing method of a reflection type optical semiconductor device is explained. FIG. 4 to FIG. 7 are explanation views of an embodiment of a manufacturing method of a reflection type optical semiconductor device of the present invention, and as similar to FIG. 2, are equivalent to a cross-sectional view in the left and right direction of the figure passing through the center of the light-emitting element chip 2, the light-emitting element wiring 9 and the mounting part electrode 13C in the reflection type optical semiconductor device shown in FIG. 1. Firstly, as shown in FIG. 4, a mounting part 3 such as an organic substrate on which mounting part electrodes 13, 13C are formed is prepared, and onto the mounting part electrode 13C of the mounting part 3 on which the reflection type optical semiconductor device is formed, the light-emitting element chip 2 is mounted by means of the conductive member 11. The light-emitting element chip 2 can be composed of a light-emitting diode, for example. On the upper surface (light-emitting portion) of the light-emitting element chip 2, a light-emitting portion 7 from which a light is emitted and a light-emitting element electrode 8 connected to a cathode of the light-emitting diode are disposed, and on the lower surface (mounting surface) of the light-emitting element chip 2, a light-emitting element electrode 8A connected to an anode of the light-emitting diode is disposed. The light-emitting element electrode 8A is connected to the mounting part electrode 13C by means of the conductive member 11 such as a silver paste, and the light-emitting element chip 2 is mounted to the mounting part 3.

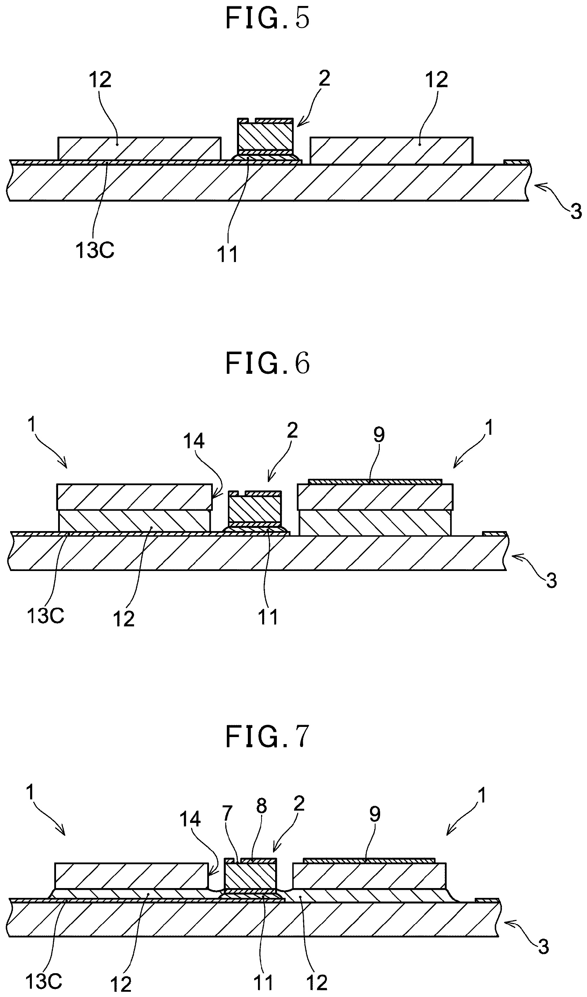

Next, as shown in FIG. 5, onto an area, on which a light-receiving element chip is supposed to be disposed, on the mounting part 3 to which the light-emitting element chip 2 has been mounted and the mounting part electrode 13C, an insulating member 12 is applied by using a dispenser or the like. It is preferable that a thickness of the applied insulating member 12 is set to be a thickness so that, when the light-receiving element chip is placed on the insulating member 12, a position in the height direction of the upper surface (light-receiving surface) of the light-receiving element chip becomes higher than a position in the height direction of the upper surface (light-emitting surface) of the light-emitting element chip 2. Further, in the step described later, the conductive member 11 is covered by the insulating member 12, and thus the thickness of the insulating member 12 in an area surrounding a through hole when the light-receiving element chip is mounted is set to be a thickness including the insulating member 12 required to cover the conductive member 11.

Next, as shown in FIG. 6, a light-receiving element chip 1 is placed on the insulating member 12. On the upper surface (light-receiving surface) of the light-receiving element chip 1, a light-receiving element array 5 composed of a plurality of light-receiving elements 4 is disposed as shown in FIG. 1. The light-receiving element 4 can be composed of a photodiode, for example. A light-receiving element electrode 6 connected to a cathode or anode of the photodiode is disposed on the light-receiving surface of the light-receiving element chip 1. On the light-receiving surface of the light-receiving element chip 1, a light-emitting element wiring 9 connected to the light-emitting element electrode 8 is also disposed. Further, the light-receiving element chip 1 comprises a through hole 14, and the light-receiving element chip 1 is placed on the insulating member 12 so that the light-emitting element chip 2 is disposed inside the through hole 14. At that time, it is preferable that a position in the height direction of the upper surface of the light-receiving element chip 1 becomes higher than a position in the height direction of the upper surface of the light-emitting element chip 2.

Next, as shown in FIG. 7, a pressure is applied to the insulating member 12 by applying a pressure from the upper surface of the light-receiving element chip 1 and then pressing the insulating member 12 with the light-receiving element chip 1. Here, the insulating member 12 is in a flowable state before curing. As a result, the insulating member 12 is pushed out to the perimeter from between the light-receiving element chip 1 and the mounting part 3, etc. The insulating member 12 pushed out into the inside of the through hole 14, in turn, covers the surface of the conductive member 11. If a position in the height direction of the upper surface of the light-receiving element chip 1 after the light-receiving element chip 1 is pressed is equal to a position in the height direction of the upper surface of the light-emitting element chip 2, a distance until a light emitted from the light-emitting element of the light-emitting element chip 2 reaches a reflector and a distance until the light reflected by the reflector reaches the light-receiving element of the light-receiving element chip 1 from the reflector become equal to each other when being used as a reflection type optical sensor, which is preferable from the viewpoint of sensing accuracy. In this way, it is preferable to set the position in the height direction of the upper surface of the light-receiving element chip 1 and the position in the height direction of the upper surface of the light-emitting element chip 2 to be equal to each other, and it is preferable that they are mounted at least in a manner that a difference in height between the position in the height direction of the upper surface of the light-receiving element chip 1 and the position in the height direction of the upper surface of the light-emitting element chip 2 becomes 40µm or less. It should be noted that, in FIG. 7, the thickness of the light-emitting element wiring 9 and the light-emitting element electrode 8 is about 1 µm or less, whereas the thickness of the light-receiving element chip 1 and the light-emitting element chip 2 is greater than 300µm, and thus the thickness of the light-emitting element wiring 9 and the light-emitting element electrode 8 is negligibly thin. It is not a problem that the position in the height direction of the upper surface of the light-receiving element chip 1 becomes lower than the position in the height direction of the upper surface of the light-emitting element chip 2.

Then, the insulating member 12 is dried and cured in a thermostatic oven, and the light-receiving element chip 1 is mounted to the mounting part 3.

With forming as described above, the conductive member 11 connecting the light-emitting element electrode 8A of the light-emitting element chip 2 to the mounting part electrode 13C is covered by the insulating member 12. In such a configuration, since the insulating member 12 functions as an adhesive that glues the light-receiving element chip 1 to the mounting part 3, and at the same time, functions as a coating material for the conductive member 11, a material thereof is selected from materials having both the functions. For example, it can be selected from an epoxy resin, a phenolic resin, polyimide, and the like. Particularly in the case where the conductive member is a material containing silver such as a silver paste, it is preferable to select a material impermeable to a sulfurizing gas in order to prevent sulfurization of silver. Specifically, a fluorine resin is preferable which is impermeable to a sulfurizing gas and also has a viscosity that allows for changing its shape so as to cover the conductive member 11, and quick-drying and heat resistance properties required for a manufacturing step or as a reflection type optical semiconductor device, and the surface of which after curing is a non-adhesive which does not allow dirt, dust, and the like to adhere.

The light-emitting element electrode 8 is connected to the light-emitting element wiring 9 disposed on the light-receiving surface of the light-receiving element chip 1 by means of the metal wire 10. The metal wire 10 is formed at a location, in a shape, and the like that do not block a light emitted from the light-emitting portion 7 of the light-emitting element chip 2. For example, the metal wire 10 is formed so as not to be disposed in an area within a light emission angle at ±60°, as an example. By disposing the metal wire in this way, the light emitted from the light-emitting portion 7 is not blocked by the metal wire 10, and degradation of the directivity property caused by the metal wire 10 can be prevented.

The light-receiving element electrode 6 and the light-emitting element wiring 9 are connected to each mounting part electrode 13 disposed on the mounting part 3 by means of the metal wire 10, to form the reflection type optical semiconductor device shown in FIG. 1. The metal wire 10 connecting any of the light-receiving element electrode 6 and the light-emitting element wiring 9 to the mounting part electrode 13 may be sealed by an epoxy resin or the like, for example.

As described above, the manufacturing method of the reflection type optical semiconductor device in the present embodiment can coat the conductive member 11 without using such a method of discharging a coating resin into the through hole 14 from the dispenser disposed on the side of the light-emitting surface of the light-emitting element chip 2, as described with FIG. 11. Therefore, it is possible to simply form a reflection type optical semiconductor device in which the light-emitting surface of the light-emitting element chip 2 is not covered by a coating resin, and thus the light emitted from the light-emitting element chip 2 is not diffused, and which has an excellent directivity property with a good symmetry of directivity and a narrow directivity angle. Further, it is possible to simply form a reflection type optical semiconductor device in which the conductive resin 11 can be surely covered and which has a high reliability.

Although a reflection type optical semiconductor device of the present invention and a production method thereof are explained above, it is needless to say that the present invention is not limited to the above-described embodiments.

### (Summary)

(1) An embodiment of a reflection type optical semiconductor device in an aspect of the present invention is a reflection type optical semiconductor device comprising: a light-emitting element chip comprising a light-emitting element and a light-emitting element electrode; a light-receiving element chip comprising a light-receiving element, a light-receiving element electrode, a light-emitting element wiring connected to the light-emitting element electrode, and a through hole in which the light-emitting element chip is disposed; and a mounting part in which a mounting part electrode to be connected to any of the light-emitting element electrode, the light-receiving element electrode, and the light-emitting element wiring is disposed, wherein the light-receiving element chip, in which the light-receiving element electrode and the light-emitting element wiring are disposed on a light-receiving surface, is mounted on the mounting part by means of an insulating member; wherein the light-emitting element chip, in which the light-emitting element electrode is disposed on each of a light-emitting surface and a mounting surface, is mounted on the mounting part by connecting the light-emitting element electrode on the mounting surface to the mounting part electrode disposed inside the through hole by means of a conductive member, wherein the conductive member is covered by the insulating member mounting the light-receiving element chip on the mounting part; wherein the light-emitting element electrode on the light-emitting surface in the light-emitting element chip is connected to the light-emitting element wiring by means of a metal wire; and wherein the light-receiving element electrode and the light-emitting element wiring are each connected to the mounting part electrode by means of a metal wire.
   According to the reflection type optical semiconductor device of the embodiment in the above-described (1), it is possible to provide a reflection type optical semiconductor device having an excellent directivity property and a high reliability, in which the conductive member is surely covered by the insulating member, while the light-emitting surface of the light-emitting element chip is not covered by a coating resin or the like.
(2) According to another embodiment, in the reflection type optical semiconductor device in the above-described (1), the conductive member contains silver, and the insulating member is composed of a material impermeable to a sulfurizing gas.
   According to the reflection type optical semiconductor device of the embodiment in the above-described (2), it is possible to provide a reflection type optical semiconductor device having a high reliability and capable of preventing sulfurization of a conductive member containing silver.
(3) An embodiment of a method of manufacturing a reflection type optical semiconductor device in another aspect of the present invention comprises: a first step of mounting a light-emitting element chip comprising a light-emitting element and, on a light-emitting surface and a mounting surface, a light-emitting element electrode to a mounting part by connecting the light-emitting element electrode disposed on the mounting surface to a mounting part electrode of the mounting part by means of a conductive member; a second step of applying an insulating member to an area in the mounting part where a light-receiving element chip is disposed; a third step of placing the light-receiving element chip comprising a light-receiving element, a light-receiving element electrode, a light-emitting element wiring to be connected to the light-emitting element electrode, and a through hole to the mounting part with the insulating member applied thereto, in a manner that the light-emitting element chip is disposed inside the through hole; a fourth step of pressing the insulating member by means of the light-receiving element chip, pushing out the insulating member from between the light-receiving element chip and the mounting part, and covering the conductive member exposed to the inside of the through hole by means of the pushed-out insulating member; a fifth step of curing the insulating member to mount the light-receiving element chip to the mounting part; and a sixth step of connecting, by means of a metal wire, the light-emitting element electrode disposed on the light-emitting surface of the light-emitting element chip and the light-emitting element wiring disposed on the light-receiving surface of the light-receiving element chip, as well as the light-receiving element electrode disposed on the light-receiving surface of the light-receiving element chip and the light-emitting element wiring to the mounting part electrode, respectively.
   According to the method of manufacturing a reflection type optical semiconductor device in an embodiment in the above-described (3), the insulating member is pressed by the light-receiving element chip to be pushed out, and the conductive member can be covered by the pushed-out insulating member, so that it is possible to simply manufacture a reflection type optical semiconductor device having an excellent directivity property and a high reliability.
(4) According to another embodiment, in the method of manufacturing a reflection type optical semiconductor device in the above-described (3), the conductive member contains silver, and the insulating member is composed of a material impermeable to a sulfurizing gas.
   According to the method of manufacturing a reflection type optical semiconductor device in the embodiment in the above-described (4), it is possible to provide a reflection type optical semiconductor device having a high reliability and capable of preventing sulfurization of the conductive member containing silver.
(5) According to yet another embodiment, in the method of manufacturing a reflection type optical semiconductor device in the above-described (3) or (4), the pressing on the insulating member by the light-receiving element chip in the fourth step is performed until a position in a height direction of an upper surface of the light-receiving element chip becomes equal to a position in a height direction of an upper surface of the light-emitting element chip.
   According to the method of manufacturing a reflection type optical semiconductor device in the embodiment in the above-described (5), a distance until a light emitted from the light-emitting element reaches a reflector and a distance until light reflected by the reflector reaches the light-receiving element from the reflector can be formed so as to be equal to each other, and it is possible to provide a reflection type optical semiconductor device constituting a reflection type optical sensor with an improved sensing accuracy.
(6) According to yet another embodiment, in the method of manufacturing a reflection type optical semiconductor device in the above-described (3) or (4), the metal wire connecting the light-emitting element electrode and the light-emitting element wiring in the sixth step is disposed so as not to block light emitted from the light-emitting element.

According to the method of manufacturing a reflection type optical semiconductor device in the embodiment in the above-described (6), it is possible to prevent deterioration of the directivity property caused by the metal wire without the light emitted from the light-emitting portion being blocked by the metal wire.

### REFERENCE SIGNS LIST

- 1, 1A, 1B: Light-receiving element chip
- 2: Light-emitting element chip
- 3, 3A, 3B: Mounting part
- 4: Light-receiving element
- 5: Light-receiving element array
- 6: Light-receiving element electrode
- 7: Light-emitting portion
- 8, 8A: Light-emitting element electrode
- 9, 9A: Light-emitting element wiring
- 10: Metal wire
- 11: Conductive member
- 12: Insulating member
- 13, 13A, 13B, 13C: Mounting part electrode
- 14: Through hole
- 15: Dispenser
- 16: Coating resin

## Claims

1. A reflection type optical semiconductor device comprising:
a light-emitting element chip comprising a light-emitting element and a light-emitting element electrode;
a light-receiving element chip comprising a light-receiving element, a light-receiving element electrode, a light-emitting element wiring connected to the light-emitting element electrode, and a through hole in which the light-emitting element chip is disposed; and
a mounting part in which a mounting part electrode to be connected to any of the light-emitting element electrode, the light-receiving element electrode, and the light-emitting element wiring is disposed,
wherein the light-receiving element chip, in which the light-receiving element electrode and the light-emitting element wiring are disposed on a light-receiving surface, is mounted on the mounting part by means of an insulating member;
wherein the light-emitting element chip, in which the light-emitting element electrode is disposed on each of a light-emitting surface and a mounting surface, is mounted on the mounting part by connecting the light-emitting element electrode on the mounting surface to the mounting part electrode disposed inside the through hole by means of a conductive member, wherein the conductive member is covered by the insulating member mounting the light-receiving element chip on the mounting part;
wherein the light-emitting element electrode on the light-emitting surface in the light-emitting element chip is connected to the light-emitting element wiring by means of a metal wire; and
wherein the light-receiving element electrode and the light-emitting element wiring are each connected to the mounting part electrode by means of a metal wire.

2. The reflection type optical semiconductor device of claim 1, wherein the conductive member contains silver, and the insulating member is composed of a material impermeable to a sulfurizing gas.

3. A method of manufacturing a reflection type optical semiconductor device, the method comprising:
a first step of mounting a light-emitting element chip comprising a light-emitting element and, on a light-emitting surface and a mounting surface, a light-emitting element electrode to a mounting part by connecting the light-emitting element electrode disposed on the mounting surface to a mounting part electrode of the mounting part by means of a conductive member;
a second step of applying an insulating member to an area in the mounting part where a light-receiving element chip is disposed;
a third step of placing the light-receiving element chip comprising a light-receiving element, a light-receiving element electrode, a light-emitting element wiring to be connected to the light-emitting element electrode, and a through hole to the mounting part with the insulating member applied thereto, in a manner that the light-emitting element chip is disposed inside the through hole;
a fourth step of pressing the insulating member by means of the light-receiving element chip, pushing out the insulating member from between the light-receiving element chip and the mounting part, and covering the conductive member exposed to the inside of the through hole by means of the pushed-out insulating member;
a fifth step of curing the insulating member to mount the light-receiving element chip to the mounting part; and
a sixth step of connecting, by means of a metal wire, the light-emitting element electrode disposed on the light-emitting surface of the light-emitting element chip and the light-emitting element wiring disposed on the light-receiving surface of the light-receiving element chip, as well as the light-receiving element electrode disposed on the light-receiving surface of the light-receiving element chip and the light-emitting element wiring to the mounting part electrode, respectively.

4. The method of manufacturing a reflection type optical semiconductor device of claim 3, wherein the conductive member contains silver, and the insulating member is composed of a material impermeable to a sulfurizing gas.

5. The method of manufacturing a reflection type optical semiconductor device of claim 3 or 4, wherein the pressing on the insulating member by the light-receiving element chip in the fourth step is performed until a position in a height direction of an upper surface of the light-receiving element chip becomes equal to a position in a height direction of an upper surface of the light-emitting element chip.

6. The method of manufacturing a reflection type optical semiconductor device of claim 3 or 4, wherein the metal wire connecting the light-emitting element electrode and the light-emitting element wiring in the sixth step is disposed so as not to block light emitted from the light-emitting element.
